# EUROPEAN PATENT APPLICATION

(11) **EP 2 172 940 A1**
(43) Date of publication of application: **07.04.2010**
(21) Application number: 09172276.9
(22) Date of filing: 06.10.2009
(51) Int. Cl.: G11C 13/00

(54) **Multi-layered memory apparatus including oxide thin film transistor**

(30) Priority: 07.10.2008 KR 20080098170
(71) Applicant: SAMSUNG ELECTRONICS CO., LTD., Suwon-si Gyeonggi-do 442-742 (KR)
(72) Inventor: Song, I-hun, Gyeonggi-do (KR); Park, Jae-chul, Gyeonggi-do (KR); Kwon, Kee-won, Gyeonggi-do (KR); Kim, Sun-il, Gyeonggi-do (KR)
(74) Representative: Greene, Simon Kenneth

(57) **Abstract**

Provided is a multi-layered memory apparatus including an oxide thin film transistor. The multi-layered memory apparatus includes an active circuit unit and a memory unit formed on the active circuit unit. A row line and a column line are formed on memory layers. A selection transistor is formed at a side end of the row line and the column line.

## Description

### BACKGROUND

### 1. Field

One or more example embodiments relate to a multi-layered memory apparatus, and more particularly, to a multi-layered memory apparatus including selection transistors formed in respective memory layers of a memory unit.

### 2. Description of the Related Art

As industries and multimedia develop, a need for large-scale information storage devices such as those used in computers or communication devices is gradually increasing. Due to such a need, research has been conducted on information devices having high information storage density and operating speed.

Conventional memory devices generally include an active circuit unit and a memory unit. The active circuit unit includes an address decoder, a read/write control logic, a sense amplifier, an output buffer and a multiplexer. In general, these elements are referred to collectively as overhead and occupy a predetermined area of a physical memory. The smaller the size of the overhead, the greater the size of a memory region.

In order to increase the memory density of a memory device, research has been conducted on developing a multi-layered memory apparatus. A multi-layered memory apparatus includes an active circuit unit including active circuits and a plurality of memory cell arrays. The active circuits support operations performed on the multi-layered memory apparatus, such as reading and writing operations. Moreover, the active circuits are formed on a silicon substrate. The plurality of memory cell arrays are stacked on the active circuit. Selection transistors for selecting memory cell arrays are formed in the active circuit unit. As the memory layers are further stacked, the size of the active circuit unit is excessively increased due to the number of selection transistors.

One or more example embodiments include a highly integrated multi-layered memory apparatus including selection transistors formed in respective multi-layered memory units.

Additional aspects will be set forth in part in the description which follows and, in part, will be apparent from the description, or may be learned by practice of the example embodiments.

An example embodiment discloses a multi-layered memory apparatus including an active circuit unit and a plurality of memory layers. The plurality of memory layers are formed on the active circuit unit. Each of the plurality of memory layers includes pluralities of row and column lines connected to the active circuit unit and selection transistors formed on at least one side end of each of the row lines and the columns lines.

At least one other example embodiment provides a multi-layered memory apparatus including an active circuit unit and a memory unit on the active circuit unit. The memory unit includes row lines connected to a row select unit and column lines connected to a column select unit. The row and column select units are on the memory unit.

Another example embodiment is directed to a multi-layered memory apparatus including an active circuit unit and a memory unit including a plurality of stacked memory cells arranged in a cross-point array. Each of the plurality of stacked memory cells includes a lower electrode connected to a first selection transistor, an upper electrode connected to a second selection transistor, and a storage node between the lower and upper electrodes.

One or more example embodiments may include a multi-layered memory apparatus including an active circuit unit, a plurality of memory layers formed on the active circuit unit. Each of the plurality of memory layers includes pluralities of row and column lines that are connected to the active circuit unit, wherein each memory layers may include selection transistors formed on at least one side end each for each of the row lines and the columns lines.

Each selection transistor may be an oxide thin film transistor (TFT).

Each memory layer may include a cross-point type memory array structure.

Each memory layer may include a switch structure and a memory region at each intersection between the row lines and the column lines.

The oxide TFT may include a gate formed on a lower structure, a gate insulating layer formed on the lower structure and the gate. A channel is formed on a portion of the gate insulating layer, which corresponds to the gate, and includes an Zn oxide. A source and a drain are formed on both side ends of the channel on the gate insulating layer.

The selection transistors may be formed alternately at both side ends of the row lines or the column lines.

The active circuit unit may include a level decoder for selecting a memory layer from among the plurality of memory arrays and a pre-decoder for selecting a memory cell of the selected memory layer.

The active circuit unit may be formed on a silicon substrate.

The pre-decoder may be connected to the selection transistors via a common.

The level decoder may be connected to gates of the selection transistors.

Even if the number of stacked memory layers is increased, the size of an active circuit unit may be minimized.

### BRIEF DESCRIPTION OF THE DRAWINGS

These and/or other aspects of the example embodiments will become apparent and more readily appreciated from the following description of the example embodiments, taken in conjunction with the accompanying drawings of which:
FIG. 1 illustrates a multi-layered memory apparatus according to an example embodiment;
FIG. 2A is a cross-sectional view of the multi-layered memory apparatus taken along a line I-I' of FIG. 1;
FIG. 2B is a cross-sectional view of the multi-layered memory apparatus taken along a line m-m' of FIG. 1;
FIG. 3 is a circuit diagram of the multi-layered memory apparatus of FIG. 1;
FIG. 4 illustrates a perspective view of a memory unit of the multi-layered memory apparatus of FIG. 1, according to an example embodiment;
FIG. 5A illustrates a multi-layered memory apparatus, according to an example embodiment;
FIG. 5B illustrates a multi-layered memory apparatus, and column lines, according to another example embodiment; and
FIG. 6 is a cross-sectional view of a thin film transistor (TFT) that may be used in the multi-layered memory apparatus of FIG. 1, according to an example embodiment.

### DETAILED DESCRIPTION

Example embodiments will be more clearly understood from the detailed description taken in conjunction with the accompanying drawings.

Various example embodiments will now be described more fully with reference to the accompanying drawings in which some example embodiments are shown. In the drawings, the thicknesses of layers and regions may be exaggerated for clarity.

Detailed illustrative example embodiments are disclosed herein. However, specific structural and functional details disclosed herein are merely representative for purposes of describing example embodiments. Other embodiments may, however, may be embodied in many alternate forms and should not be construed as limited to only the example embodiments set forth herein.

Accordingly, while example embodiments are capable of various modifications and alternative forms, example embodiments thereof are shown by way of example in the drawings and will herein be described in detail. It should be understood, however, that there is no intent to limit example embodiments to the particular forms disclosed, but on the contrary, example embodiments are to cover all modifications, equivalents, and alternatives falling within the scope of the example embodiments. Like numbers refer to like elements throughout the description of the figures.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of example embodiments. As used herein, the term "and/or" includes any and all combinations of one or more of the associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Other words used to describe the relationship between elements should be interpreted in a like fashion (e.g., "between" versus "directly between", "adjacent" versus "directly adjacent", etc.).

The terminology used herein is for the purpose of describing particular example embodiments only and is not intended to be limiting of example embodiments. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Also, the use of the words "compound," "compounds," or "compound(s)," refer to either a single compound or to a plurality of compounds. These words are used to denote one or more compounds but may also just indicate a single compound.

Now, in order to more specifically describe example embodiments, various example embodiments will be described in detail with reference to the attached drawings. In the figures, if a layer is formed on another layer or a substrate, it means that the layer is directly formed on another layer or a substrate, or that a third layer is interposed therebetween. In the following description, the same reference numerals denote the same elements.

According to at least one example embodiment, a multi-layered memory apparatus may include a memory unit having a plurality of memory arrays formed on an active circuit unit and an oxide thin film transistor (TFT) may be formed as a selection transistor for each memory array.

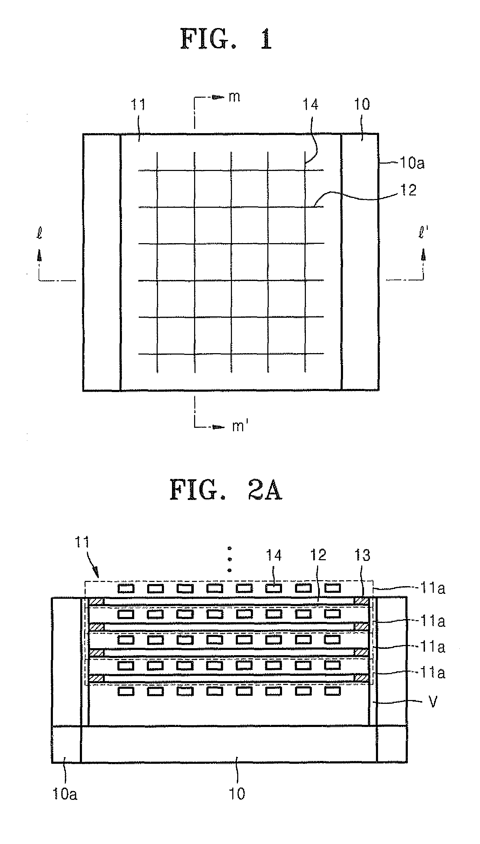

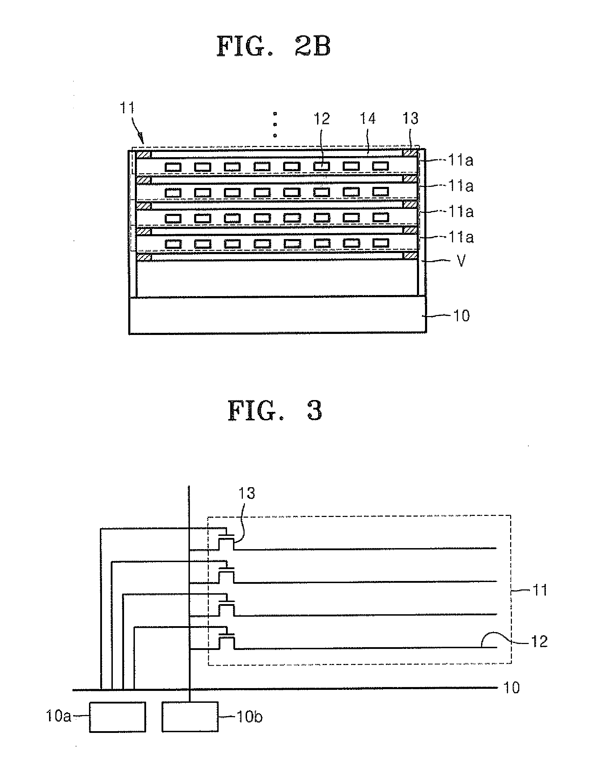

FIGS. 1, 2A and 2B illustrate a multi-layered memory apparatus including an oxide TFT, according to an example embodiment. FIG. 1 is a plan view of the multi-layered memory apparatus. FIG. 2A is a cross-sectional view of the multi-layered memory apparatus taken along a line I-I' of FIG. 1. FIG. 2B is a cross-sectional view of the multi-layered memory apparatus taken along a line m-m' of FIG. 1.

Referring to FIGS. 1, 2A and 2B, a memory unit 11 is formed on an active circuit unit 10. The memory unit 11 includes a plurality of memory layers 11 a formed on the active circuit unit 10. Each of the memory layers 11 a may be formed in an array shape, and may include a plurality of memory arrays.

The memory layers 11a may include a plurality of row lines 12 formed in a first direction and a plurality of column lines 14 formed in a second direction (e.g., normal to the first direction). A storage node (not shown) may be formed between the pluralities of row and column lines 12 and 14. A plurality of selection transistors 13 are formed at first and second ends of the row lines 12 and the column lines 14, and may be connected to the active circuit unit 10 via a common v. The active circuit unit 10 may also include a decoder, read/write control logic and a sense amplifier for supporting a memory operation, such as reading and writing operations performed on the memory unit 11. The active circuit unit 10 may be formed on a silicon substrate by using a general manufacturing process.

A level decoder 10a (a first decoder) for selecting a memory layer 11 a of the memory unit 11 is formed on at least one side end of the active circuit unit 10 of the multi-layered memory apparatus. In addition, a pre-decoder 10b (a second decoder illustrated in FIG. 3) for selecting a cell of a selected memory layer is formed to be connected to the selection transistors 13 via the common v.

FIG. 3 is a circuit diagram of the multi-layered memory apparatus of FIG. 1.

Referring to FIG. 3, the level decoder 10a and the pre-decoder 10b are formed in the active circuit unit 10. The level decoder 10a is connected to gates of the selection transistors 13 that are connected to the row lines 12 of each memory layer of the memory unit 11. The pre-decoder 10b is connected to a source or drain of the selection transistors 13 connected to the row lines 12 or the column lines 14 of each memory layer. As shown in FIG. 3, the level decoder 10a and the pre-decoder 10b are connected to the selection transistors 13 that are connected to the row lines 12.

An operation performed on the multi-layered memory apparatus will be described in detail. First, when the active circuit unit 10 selects a memory layer 11 a, a signal is applied to the selection transistor 13 of the selected memory layer 11 a of the memory unit 11 through the level decoder 10a. In order to select a memory cell of the selected memory layer 11a, a signal is applied from the pre-decoder 10b to the selection transistor 13 connected to the row or column lines 12 or 14 of the selected memory layer 11a. As shown in FIG. 3, the selection transistors 13 are connected to the row lines 12, but the selection transistors 13 may be connected to the column lines 14.

As illustrated in FIGS. 1 through 3, a row decoder is divided into the pre-decoder 10b and the selection transistors 13 serving as a row select unit. The pre-decoder 10b is disposed on the active circuit unit 10. Each selection transistor 13 is formed on one of the memory layers 11 a. If both the pre-decoder 10b and the selection transistors 13 are on the active circuit unit 10, the multi-layered memory apparatus is spatially inefficient. However, when the selection transistors 13 are formed on the memory unit 11 so as to be connected to the row lines 12 or the column lines 14, the size of the active circuit unit 10 may be prevented from increasing.

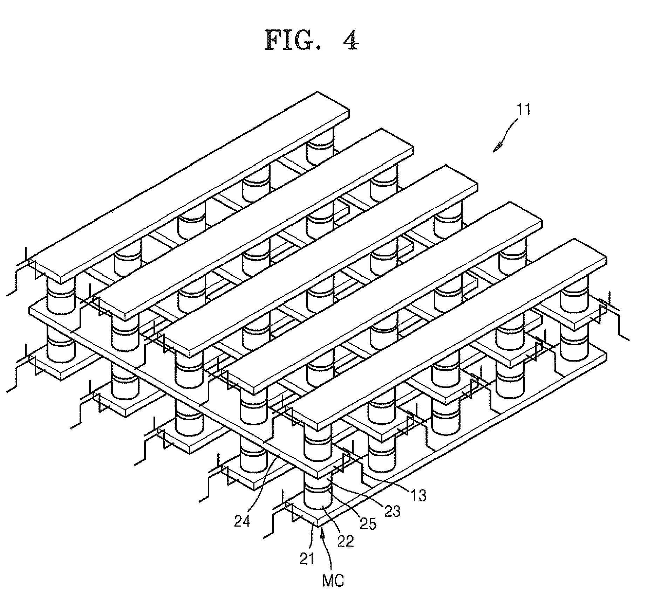

FIG. 4 is a perspective view of the memory unit of the multi-layered memory apparatus of FIG. 1, according to an example embodiment.

Referring to FIG. 4, the memory unit 11 includes a plurality of memory cells MC arranged in an array. Each memory cell MC includes a lower electrode 21 formed in a first direction, a switch structure 22 formed on the lower electrode 21, a memory region 23, and an upper electrode 24 formed on the memory region 23 in a second direction. The lower electrode 21, the switch structure 22, the memory region 23, and the upper electrode 24 are sequentially staked.

The switch structure 22 may be formed as a diode. The memory region 23 may be formed of an information storage material, such as a transition metal oxide having a variable resistance. The memory cell MC further includes an intermediate electrode 25 between the switch structure 22 and the memory region 23. The switch structure 22, memory region 23 and intermediate electrode 25 may form a storage node. The memory array structure of FIG. 4 is a cross-point type memory. Additional electrode lines, switch structures and memory regions are formed on the upper electrode 24 to form additional memory cells and storage nodes.

The lower electrode 21 and the upper electrode 24 may correspond to row lines 12 and column lines 14, respectively. The selection transistors 13 are formed at side ends of the lower electrodes 21 and the upper electrodes 24.

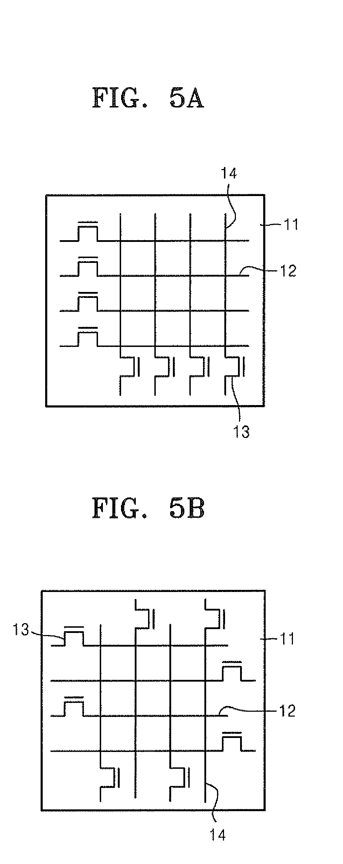

The selection transistors 13 may be formed at either side end of each of the row lines 12 and the column lines 14. Areas where the selection transistors 13 are formed may be selectively determined and may be changed during the design of the multi-layered memory apparatus. For example, as illustrated in FIG. 5A, the selection transistors 13 may be formed at only one side for each of the row and column lines 12 and 14. Alternatively, as illustrated in FIG. 5B, the selection transistors 13 may be formed at alternating side ends of the row lines 12 and the column lines 14.

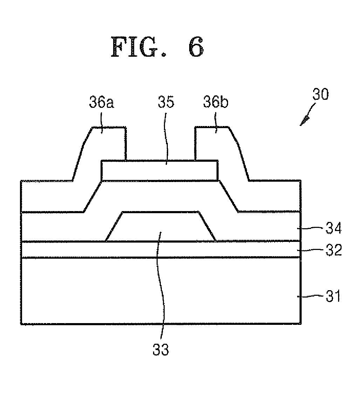

FIG. 6 is a cross-sectional view of a TFT that may be used as a selection transistor in the multi-layered memory apparatus of FIG. 1, according to an example embodiment. In FIG. 6, the TFT is a bottom gate type TFT.

Referring to FIG. 6, a TFT 30 includes a gate 33 formed on a lower structure 31 and an oxide layer 32. It should be understood that the gate 33 may be directly formed on the lower structure 31, thereby omitting the oxide layer 32. A gate insulating layer 34 is formed on the lower structure 31 and the gate 33. A channel 35 is formed on a portion of the gate insulating layer 34, which overlaps the gate 33. A source 36a and a drain 36b are formed at side ends of the channel 35 on the gate insulating layer 34.

The lower structure 31 may be formed of a substrate material that is generally used in a semiconductor device, or alternatively, may be formed with an oxide and a nitride formed on the substrate material. The gate insulating layer 34 may be formed of a general insulating material, or alternatively, may be formed of SiO2 or a high-K material having a higher dielectric constant than that of SiO2.

The channel 35 may be formed of a Zn-based oxide or of a compound including a Zn-based oxide and metals such as Ga, In, Sn or Al. The channel 35 may be formed in a thin film. The channel 35 may have a thickness in the range of about 20 to about 200 nm. For example, the channel 35 may be formed of a compound of Ga203, In2O3, and ZnO. The channel 35 may be formed using a deposition process in which a compound of Zn and a metal (e.g., Ga, In, Sn or Al) is sputtered as a single target, or in which ZnO and Ga, In, Sn or Al are co-sputtered. For example, when the single target is used, a compound target including Ga203, In2O3 and ZnO of a 2:2:1 ration may be used. Then, annealing is performed at a temperature of about 250°C in a gas atmosphere, such as N2.

The active circuit unit 10 may be formed using a Si process. However, with regard to a selection transistor, since the selection transistor is not formed on the active circuit unit 10, it is difficult to use a Si-based epi-growth process. In addition, a high-temperature process may be performed at a temperature higher than about 900°C as a re-crystallization temperature. Thus, the multi-layered memory apparatus according to the example embodiment may use an oxide TFT as the selection transistor.

As described above, according to the one or more of the above example embodiments, It would be understood by one of ordinary skill in the art that various electronic devices or apparatuses including the multi-layered memory apparatus may be manufactured using an oxide TFT.

It should be understood that the example embodiments described therein should be considered in a descriptive sense only and not for purposes of limitation. Descriptions of features or aspects within each embodiment should typically be considered as available for other similar features or aspects in other embodiments.

## Claims

1. A multi-layered memory apparatus comprising:
an active circuit unit (10); and
a plurality of memory layers (11a) formed on the active circuit unit, each of the plurality of memory layers including:
pluralities of row and column lines (12,14) connected to the active circuit unit, and
selection transistors (13) formed on at least one side end of each of the row lines and the columns lines.

2. The multi-layered memory apparatus of claim 1, wherein each selection transistor (13) is an oxide thin film transistor (TFT).

3. The multi-layered memory apparatus of claim 2, wherein each of the memory layers (11a) is arranged as a cross-point type memory array wherein the row lines and the column lines intersect.

4. The multi-layered memory apparatus of claim 3, wherein each of the plurality of memory layers (11a) includes a switch structure (22) and a memory region (23) at each intersection between the row lines and the column lines.

5. The multi-layered memory apparatus of claim 4, wherein an intermediate electrode (25) is between each switch structure and memory region.

6. The multi-layered memory apparatus of claim 2, wherein the oxide TFT includes:
a gate (33) formed on a lower structure,
a gate insulating layer (34) formed on the lower structure and the gate,
a channel (35) formed on a portion of the gate insulating layer, the channel and including an Zn oxide, and
a source (36a) and a drain (36b) formed on ends of the channel.

7. The multi-layered memory apparatus of claim 1, wherein the selection transistors (13) are formed at alternating ends of at least one of the row lines and the column lines.

8. The multi-layered memory apparatus of claim 1, wherein the active circuit unit (10) includes:
a first decoder (10a) configured to select a first memory layer of the plurality of memory layers, and
a second decoder (10b) configured to select a memory cell of the first memory layer.

9. The multi-layered memory apparatus of claim 8, wherein the first decoder (10a) is connected to gates of the selection transistors.

10. A multi-layered memory apparatus comprising:
an active circuit unit (10); and
a memory unit (11) on the active circuit unit, the memory unit including row lines (12) connected to a row select unit (13) and column lines (14) , the row select unit (13) being on the memory unit.

11. The multi-layered memory apparatus of claim 10, wherein the memory unit includes a plurality of memory layers (11 a).

12. The multi-layered memory apparatus of claim 11, wherein each of the plurality of memory layers (11a) includes row lines coupled to a row select unit (13).

13. The multi-layered memory apparatus of claim 10, wherein the active unit circuit unit includes,
a first decoder (10a) configured to select a first memory layer of the plurality of memory layers, and
a second decoder (10b) configured to select a memory cell of the first memory layer.

14. A multi-layered memory apparatus comprising:
an active circuit unit (10); and
a memory unit (11) comprising a plurality of stacked memory cells arranged in a cross-point array, each of the plurality of stacked memory cells including:
a lower electrode (21) connected to a first selection transistor,
an upper electrode (24) connected to a second selection transistor, and
a storage node (22,23,25) between the lower and upper electrodes.

15. The multi-layered memory apparatus of claim 14, wherein each of the first and second selection transistors is an oxide thin film transistor (TFT) including,
a gate (33) formed on a lower structure,
a gate insulating layer (34) formed on the lower structure and the gate,
a channel (35) formed on a portion of the gate insulating layer and including an Zn oxide, and
a source (36a) and a drain (36b) formed on ends of the channel.
